# EUROPÄISCHE PATENTANMELDUNG

(11) **EP 1 959 301 A1**
(43) Veröffentlichungstag der Anmeldung: **20.08.2008**
(21) Anmeldenummer: 07102354.3
(22) Anmeldetag: 14.02.2007
(51) Int. Cl.: G03F 7/16, H01L 21/00, B05C 11/08

(54) **Vorrichtung und Verfahren zum Rotationsbeschichten**

(71) Anmelder: Levitronix LLC, Waltham, MA 02451 (US)
(72) Erfinder: Scöb, Reto, 8964 Rudolfstetten (CH)
(74) Vertreter: Sulzer Management AG

(57) **Zusammenfassung**

Es wird eine Vorrichtung vorgeschlagen zum Rotationsbeschichten einer Oberfläche eines Substrats mit einem Fluid, insbesondere der Oberfläche eines Wafers mit einer Polymerflüssigkeit, speziell mit einem Photoresist, welche einen Drehteller (2) zum Aufnehmen des Substrats (11) umfasst, eine Antriebseinrichtung (3) zum Rotieren des Drehtellers (2), eine Abgabedüse (4) zum Aufbringen einer vorgebbaren Menge von Fluid auf die Oberfläche des Substrats (11) zwecks Bildung einer Schicht (12), sowie eine Pumpe (5) zum Fördern des Fluids, die einerseits mit einer Quelle (20) für das Fluid und andererseits mit der Abgabedüse (4) verbindbar ist. Es ist ein Viskosimeter (6) vorgesehen, mit welchem vor dem Aufbringen des Fluids dessen aktuelle Viskosität messtechnisch bestimmbar ist. Ferner wird ein entsprechendes Verfahren vorgeschlagen.

## Beschreibung

Die Erfindung betrifft eine Vorrichtung und ein Verfahren zum Rotationsbeschichten einer Oberfläche eines Substrats mit einem Fluid gemäss dem Oberbegriff des unabhängigen Anspruchs der jeweiligen Kategorie. Insbesondere betrifft die Erfindung eine Vorrichtung und ein Verfahren zum Rotationsbeschichten einer Oberfläche eines Wafers mit einer Polymerflüssigkeit, speziell mit einem Photoresist.

In der Halbleitertechnologie und in der Mikroelektronik wird - beispielsweise bei der Herstellung integrierter Schaltkreise das Verfahren des Rotationsbeschichtens (spin-coating) angewendet, um mittels eines Fluids eine Schicht auf der Oberfläche eines Substrats herzustellen.

Zum Herstellen integrierter Schaltkreise oder mikroelektronischer Strukturen ist es notwendig, geometrische Formen wie z.B. Leiterbahnen auf den Wafer zu übertragen. Dies geschieht in aller Regel mit Hilfe eines litographischen Prozesses, bei dem zunächst eine dünne Schicht eines Photoresists (auch als Photolack bezeichnet) auf die Oberfläche des Wafers aufgebracht wird. Nach deren Trocknung wird durch Beaufschlagung dieser Schicht mit elektromagnetischer Strahlung - üblicherweise UV-Licht - durch eine Maske hindurch die gewünschte geometrische Struktur aufbelichtet. Dort, wo die Maske die Photoresistschicht nicht abdeckt, wird deren Löslichkeit durch die Strahlung entweder erhöht (Positivlack) oder erniedrigt (Negativlack), sodass im anschliessenden Bearbeitungsschritt entweder die bei der Belichtung nicht abgedeckten Bereiche oder die abgedeckten Bereiche herausgelöst werden.

Beim Rotationsbeschichten wird die Schicht auf der Oberfläche des Wafers generiert, indem der Wafer auf einem Drehteller (Chuck) angeordnet wird, der Drehteller in Rotation versetzt wird und dann mittels einer Dosiereinrichtung über dem Zentrum des Wafers eine vorgebbare Menge einer Polymerflüssigkeit, die ausser dem Polymer ein Lösungsmittel enthält, aufgebracht wird. Durch die Rotation des Drehtellers, die üblicherweise mit 100 bis 6000 Umdrehungen pro Minute erfolgt, verteilt sich die Polymerflüssigkeit als dünne Schicht auf der Waferoberfläche. Um eine feste Schicht zu erzeugen, muss anschliessend das Lösungsmittel entfernt werden, was durch Rotieren - typischerweise bei geringeren Drehzahlen - oder Heizen des Wafers bzw. der Prozesskammer unterstützt werden kann. Derartige Prozesse sind beispielsweise in der US-A-6,662,466 oder in der US-A-2004/0009295 offenbart.

Ein wesentliche Aspekt bei der Herstellung der Photoresistschichten ist es, dass die Variationen in der Schichtdicke über die gesamte Waferoberfläche gesehen möglichst klein gehalten werden sollen. Dies liegt unter anderem daran, dass man aufgrund der extrem kleinen Strukturen, die auf den Wafer belichtet werden, möglichst kurzwelliges Licht verwendet, wodurch die Tiefenschärfe bei der Belichtung sehr klein ist, beispielsweise 150 nm.

Zudem ist man bemüht, die Schichten sehr dünn zu gestalten und den Photoresist möglichst effizient zu verwenden, weil es sich hierbei um relativ teure Substanzen handelt. Ein Wegschleudern von Photoresist von der Waferoberfläche soll möglichst weitgehend vermieden werden. Daher ist man bemüht, die Parameter, welche die Dicke der erzielten Schicht beieinflussen, möglichst genau einzustellen. Diese Parameter umfassen die Rotationsgeschwindigkeit des Drehtellers, die Temperatur des Wafers und die Viskosität der Polymerflüssigkeit, um nur einige zu nennen. Die Viskosität wiederum hängt üblicherweise sehr stark von der Temperatur ab, aber auch von der Zusammensetzung der Polymerflüssigkeit. Es kann sogar sein, dass sich innerhalb einer Vorratsflasche für die Polymerlösung deren Viskosität ändert, weil das Verhältnis aus Lösungsmittel und Polymer räumlich und/oder zeitlich nicht konstant ist.

Um eine möglichst homogene Schichtdicke zu erzielen, wird in der US-A-2004/0009295 vorgeschlagen, zunächst eine Mehrzahl von Proben herzustellen, bei denen die Beschichtung durch schrittweises Verändern einzelner Parameter bewusst verändert wird, und anschliessend durch Auswerten der empirisch gewonnenen Daten die optimalen Parameter zu bestimmen.

In der US-A-6,662,466 wird vorgeschlagen, zum Trocknen des Polymers die Temperaturen des Polymermaterials, die Substrattemperatur und die Umgebungstemperatur in der Nähe des Substrats zu messen. Wenn sich die Umgebungstemperatur ändert, wird dann die Substrattemperatur, die Polymertemperatur, die Umgebungstemperatur oder die Rotationsgeschwindigkeit bei der Trocknung des Polymers entsprechend angepasst.

Ein ähnliches Problem der Herstellung dünner Schichten möglichst gleichmässig Dicke auf einem Substrat existiert beispielsweise auch bei der Herstellung von CDs oder DVDs. Diesbezüglich wird in der US-A-6,814,825 vorgeschlagen, zunächst auf einem ersten Substart eine Flüssigkeitsschicht aufzubringen, das erste Substrat zu rotieren, dann ein zweites Substrat auf der Flüssigkeitsschicht zu deponieren und durch Rotation überschüssige Flüssigkeit auszuschleudern. Die resultierende Schichtdicke wird gemessen. Werden Abweichungen von dem gewünschten Wert festgestellt, so wird die Substrattemperatur oder die Temperatur der Flüssigkeit für die Schicht entsprechend geändert.

Ausgehend von diesem Stand der Technik, ist es eine Aufgabe der Erfindung, eine Vorrichtung und ein Verfahren zum Rotationsbeschichten einer Oberfläche eines Substrats vorzuschlagen, mit welchen dünne Schichten möglichst gleichmässiger Dicke generierbar sind. Insbesondere sollen die Vorrichtung und das Verfahren für das Beschichten einer Oberfläche eines Wafers mit einer Polymerflüssigkeit, speziell mit einem Photoresist, geeignet sein.

Die diese Aufgabe in apparativer und verfahrenstechnischer Hinsicht lösenden Gegenstände der Erfindung sind durch die unabhängigen Ansprüche der jeweiligen Kategorie gekennzeichnet.

Erfindungsgemäss wird also eine Vorrichtung vorgeschlagen zum Rotationsbeschichten einer Oberfläche eines Substrats mit einem Fluid, insbesondere der Oberfläche eines Wafers mit einer Polymerflüssigkeit, speziell mit einem Photoresist, welche einen Drehteller zum Aufnehmen des Substrats umfasst, eine Antriebseinrichtung zum Rotieren des Drehtellers, eine Abgabedüse zum Aufbringen einer vorgebbaren Menge von Fluid auf die Oberfläche des Substrats zwecks Bildung einer Schicht, sowie eine Pumpe zum Fördern des Fluids, die einerseits mit einer Quelle für das Fluid und andererseits mit der Abgabedüse verbindbar ist. Es ist ein Viskosimeter vorgesehen, mit welchem vor dem Aufbringen des Fluids dessen aktuelle Viskosität messtechnisch bestimmbar ist.

Da beim Rotationsbeschichten die Viskosität des Fluids einer der wesentlichen Faktoren ist, welche die Schichtdicke bzw. die Homogenität der Schichtdicke beeinflussen, lässt sich durch die messtechnische Erfassung der aktuellen Viskosität mittels eines Viskosimeters gewährleisten, dass Schwankungen in der Viskosität des Fluids noch vor dessen Aufbringen auf die zu beschichtende Oberfläche detektiert werden können. Somit lassen sich Inhomogenitäten in der Schichtdicke, die durch Variationen in der Viskosität bedingt sind, zumindest deutlich reduzieren. Da die Viskosität messtechnisch erfasst wird, ist es auch unerheblich, ob deren Schwankungen auf einer Änderung der Temperatur des Fluids beruhen oder auf einer Änderung in der Zusammensetzung des Fluids oder auf sonstigen Änderungen. Durch das Viskosimeter ist jede Änderung der Viskosität feststellbar unabhängig von ihrer Ursache. Überraschend ist hierbei die Erkenntnis, dass mit einem Viskosimeter - auch bei einer in-line-Messung - Schwankungen in der Viskosität mit genügender Genauigkeit detektiert werden können. Wird festgestellt, dass sich die Viskosität des Fluids geändert bzw. zu stark geändert hat, so können Gegenmassnahmen ergriffen werden, beispielsweise kann das Aufbringen des Fluids auf das Substrat unterbunden werden, sodass es nicht zu einer fehlerhaften oder qualitativ unbefriedigenden Beschichtung des Substrats kommt.

Vorzugsweise ist eine Kontrolleinrichtung vorgesehen, welche mit dem Viskosimeter signalverbunden ist und beim Abweichen der aktuellen Viskosität des Fluids von einem Soll-Wert eine Kompensation einleitet, mit der Variationen in der Dicke der auf der Oberfläche aufzubringenden Schicht entgegengewirkt wird. Durch eine solche Kompensation ist es möglich, die detektierten Änderungen in der Viskosität durch die Variation von Parametern auszugleichen, sodass die Beschichtung durchgeführt werden kann und die gewünschte Schichtdicke realisiert wird. Solche Kompensationen können beispielsweise direkt die Viskosität des Fluids ändern oder andere Parameter, die dann die durch die Viskositätsschwankung verursachte Änderung kompensieren.

Es ist vorteilhaft, wenn eine Temperierung zur Änderung der Temperatur des Fluids vorgesehen ist, weil so auf einfache Weise die Viskosität des Fluids beeinflusst werden kann.

In einer bevorzugten Ausgestaltung ist der Drehteller zum Aufnehmen des Substrats in einer Prozesskammer vorgesehen, wobei ferner eine Klimaeinheit vorgesehen ist, mit welcher zumindest die Temperatur in der Prozesskammer einstellbar ist. Auf diese Weise lässt sich nämlich zumindest die Temperatur des Substrats kontrollieren. Optional sind auch andere für die erzielte Schichtdicke relevante Parameter einstellbar, beispielsweise die Feuchte.

In einer besonders bevorzugten Ausgestaltung ist als Quelle für das Fluid eine Versorgungseinheit vorgesehen, mit einem ersten Vorratsbehälter für eine erste Komponente des Fluids, mit einem zweiten Vorratsbehälter für eine zweite Komponente des Fluids, mit einer Mischeinrichtung zum Durchmischen der Komponenten des Fluids, sowie mit einer Steuer- und Regeleinheit, mit welcher das Mengenverhältnis der Komponenten des Fluids einstellbar ist. Diese Ausgestaltung erlaubt es nämlich auch, die Viskosität des Fluids dadurch einzustellen, dass seine Zusammensetzung geändert wird. Beispielsweise kann im Falle von Photoresist als Fluid das Verhältnis von Polymer zu Lösungsmittel geändert werden, um so die Viskosität des Fluids zu ändern.

Bei dieser Ausgestaltung kann vorteilhafterweise das Viskosimeter in der Versorgungseinheit vorgesehen sein. Hierdurch wird es beispielsweise möglich, das Fluid zunächst solange in der Versorgungseinheit zu zirkulieren, bis der aktuelle Wert der Viskosität mit dem Soll-Wert übereinstimmt und das Fluid erst dann der Abgabedüse zuzuführen.

In der Praxis ist es besonders günstig, wenn die Kompensation zumindest eine der folgenden Massnahmen umfasst: Änderung der Temperatur des Fluids, Änderung der Rotationsgeschwindigkeit des Drehtellers, Änderung der Temperatur in der Prozesskammer; Änderung der Zusammensetzung des Fluids durch Änderung des Mengenverhältnisses der Komponenten des Fluids.

Erfindungsgemäss wird ferner ein Verfahren vorgeschlagen zum Rotationsbeschichten einer Oberfläche eines Substrats mit einem Fluid, insbesondere der Oberfläche eines Wafers mit einer Polymerflüssigkeit, speziell mit einem Photoresist, bei welchem Verfahren das Substrat auf einem Drehteller angeordnet wird, der Drehteller rotiert wird, mit einer Abgabedüse eine vorgebbare Menge des Fluids auf die Oberfläche des Subsrats zwecks Bildung einer Schicht aufgebracht wird, wobei das Fluid mittels einer Pumpe von einer Quelle für das Fluid zu der Abgabedüse gefördert wird. Vor dem Aufbringen des Fluids wird dessen aktuelle Viskosität mittels eines Viskosimeters messtechnisch bestimmt.

Die Erläuterungen bezüglich der Vorrichtung gelten in sinngemäss gleicher Weise auch für das Verfahren.

Aus den bereits genannten Gründen ist es auch bei dem erfindungsgemässen Verfahren bevorzugt, dass mittels einer Kontrolleinrichtung, die mit dem Viskosimeter signalverbunden ist, die aktuelle Viskosität des Fluids mit einem Soll-Wert verglichen wird und im Falle einer Abweichung eine Kompensation eingeleitet wird, mit der Variationen in der Dicke der auf der Oberfläche aufzubringenden Schicht entgegengewirkt wird.

Auch verfahrenstechnisch ist es eine vorteilhafte Variante, wenn die aktuelle Viskosität in einer als Quelle für das Fluid vorgesehenen Versorgungseinheit mittels eines Viskosimeters messtechnisch bestimmt wird.

Zur Kompensation wird vorzugsweise zumindest eine der folgenden Massnahmen durchgeführt: Änderung der Temperatur des Fluids, Änderung der Rotationsgeschwindigkeit des Drehtellers, Änderung der Temperatur in einer Prozesskammer für den Drehteller, Änderung der Zusammensetzung des Fluids durch Änderung des Mengenverhältnisses von Komponenten des Fluids.

Weitere vorteilhafte Massnahmen und bevorzugte Ausgestaltungen der Erfindung ergeben sich aus den abhängigen Ansprüchen.

Im Folgenden wird die Erfindung anhand von Ausführungsbeispielen und anhand der Zeichnung sowohl in apparativer als auch in verfahrenstechnischer Hinsicht näher erläutert. In der schematischen Zeichnung zeigen teilweise im Schnitt:
- Fig. 1:: ein erstes Ausführungsbeispiel einer erfindungsgemässen Vorrichtung zum Rotationsbeschichten,
- Fig. 2:: ein zweites Ausführungsbeispiel einer erfindungsgemässen Vorrichtung zum Rotationsbeschichten, und
- Fig. 3:: ein Ausführungsbeispiel einer Versorgungseinheit für die erfindungsgemässe Vorrichtung.

Durch die Erfindung werden eine Vorrichtung und ein Verfahren zum Rotationsbeschichten einer Oberfläche eines Substrats mit einem Fluid vorgeschlagen. Im Folgenden wird auf den für die Praxis besonders wichtigen Fall Bezug genommen, dass die zu beschichtende Oberfläche die Oberfläche eines Wafers ist und das Fluid ein Photoresit (Fotolack) ist, mit dem der Wafer beschichtet werden soll, um anschliessend die gewünschten Strukturen auf den Wafer zu belichten. Es versteht sich aber, dass die Erfindung nicht auf solche Anwendungen beschränkt ist, sondern auch für andere Prozesse geeignet ist, bei denen auf der Oberfläche eines Substrats mittels Rotationsbeschichten eine insbesondere dünne Schicht eines Fluids generiert werden soll. Andere Beispiele sind die Herstellung von CDs oder DVDs. Dabei kann die hergestellte Schicht auch eine Bond- oder Verbindungsschicht sein, auf die dann ein zweites Substrat aufgebracht wird. Nätürlich können auch andere Fluide als Photoresist mit der erfindungsgemässen Vorrichtung bzw. dem erfindungsgemässen Verfahren verarbeitet werden, insbesondere Polymerflüssigkeiten.

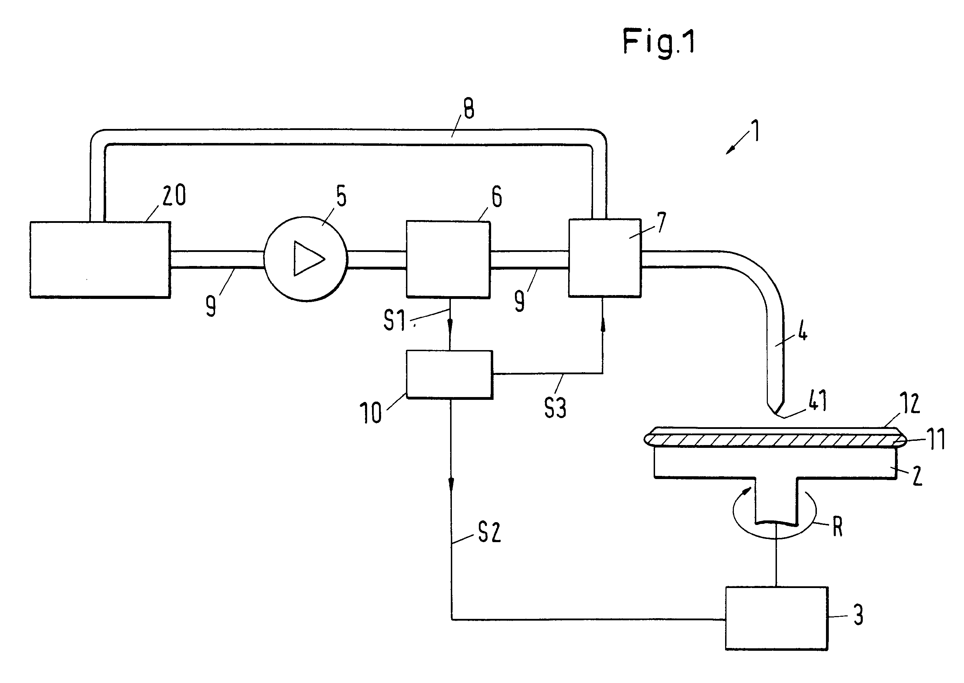

Fig. 1 zeigt in einer schematischen Darstellung ein erstes Ausführungsbeispiel einer erfindungsgemässen Vorrichtung zum Rotationsbeschichten (spin-coating) einer Oberfläche eines Substrats, die gesamthaft mit dem Bezugszeichen 1 bezeichnet ist.

Die Vorrichtung 1 umfasst einen Drehteller 2, der auch als Chuck bezeichnet wird, und welcher der Aufnahme eines Substrats 11, hier eines Wafers 11 dient. Auf dem Wafer 11 soll eine Schicht 12 eines Fluids, hier eines Photoresists generiert werden, die möglichst geringe Variationen in ihrer Dicke aufweist. Im Betriebszustand wird der Wafer 11 mit an sich bekannten Methoden, beispielsweise mittels Unterdruck- oder Vakuumtechnik auf dem Drehteller 2 gehalten.

Ferner ist eine Antriebseinrichtung 3 vorgesehen, mit welcher der Drehteller 2 rotiert werden kann, wie dies der Pfeil mit dem Bezugszeichen R andeutet.

Darstellungs oberhalb des Drehtellers 2 ist eine Abgabedüse 4 vorgesehen. Durch diese wird eine vorgebbare Menge des Fluids auf die Oberfläche des Substrats 11 aufgebracht, um dort die Schicht 12 zu erzeugen. Im vorliegenden Fall ist die Abgabedüse 4 stationär angeordnet, und zwar so, dass sich ihre Austrittsöffnung 41, durch welche das Fluid austritt, oberhalb des Zentrums des Drehtellers 2 befindet. Es sind jedoch auch solche Ausgestaltungen möglich, bei denen die Abgabedüse 4 beweglich relativ zum Drehteller 2 angeordnet ist, sodass ihre Position bezüglich des Drehtellers 2 kontrolliert veränderbar ist.

Ferner ist eine Pumpe 5 vorgesehen, mit welcher das Fluid von einer Quelle 20 für das Fluid durch eine als Leitung ausgestaltete Zuführung 9 zu der Abgabedüse 4 gefördert wird. Vorzugsweise ist die Pumpe 5 als Dosierpumpe 5 ausgestaltet, mit der jeweils eine vorgebbare Menge an Fluid für die Beschichtung eines Wafers 11 zur Abgabedüse 4 gefördert wird. Die Pumpe 5 kann natürlich auch in an sich bekannter Weise als Filterpumpe mit integriertem Filter ausgestaltet sein oder in Form einer Pumpe-Filter-Pumpe-Einheit, bei welcher die erste Pumpe den Druckaufbau für das Durchströmen des Filters realisiert und die zweite Pumpe der Förderung des Fluids zur Abgabedüse 4 dient.

Erfindungsgemäss umfasst die Vorrichtung 1 ferner ein Viskosimeter 6, mit welchem vor dem Aufbringen des Fluids auf die Waferoberfläche dessen aktuelle Viskosität messtechnisch bestimmbar ist. Bei diesem Ausführungsbeispiel ist das Viskosimeter 6 zwischen dem Ausgang der Pumpe 5 und der Abgabedüse 4 in der Zuführung 9 vorgesehen. Das Viskosimeter ist in-line angeordnet, das heisst, von dem in der Zuführung 9 strömenden Fluid wird während des Betriebs der Vorrichtung 1 die aktuelle Viskosität gemessen. Ganz besonders geeignet sind hierfür solche Viskosimeter, wie sie von der Anmelderin kommerziell erhältlich sind. Diese Viskosimeter sind beispielsweise in der US-A-6,640,617 (P.7176) offenbart.

Es handelt sich hierbei um ein Rotationsviskosimeter. Dieses umfasst einen elektrischen Drehantrieb mit einem Stator, der eine Statorwicklung aufweist und einem in dem Fluid rotierbaren Rotationskörper. Der Rotationskörper ist als Rotor des Drehantriebs ausgestaltet und ist bezüglich des Stators berührungslos magnetisch gelagert.

Bei dem in Fig. 1 dargestellten Ausführungsbeispiel ist das Viskosimeter 6 über eine Datenleitung S1 mit einer Kontrolleinrichtung 10 signalverbunden, um den jeweils messtechnisch bestimmten aktuellen Wert der Viskosität des Fluids an die Kontrolleinrichtung zu übermitteln. Die Kontrolleinrichtung 10 ist ferner über eine Datenleitung S2 mit der Antriebseinrichtung 3 für den Drehteller 2 verbunden.

Zwischen dem Viskosimeter 6 und der Abgabedüse 4 ist in der Zuführung 9 ein Ventil 7 vorgesehen, dass als Dreiwegeventil ausgestaltet ist und die Zuführung 9 wahlweise mit der Abgabedüse 4 oder mit einer Rückführung 8 verbindet. Das Ventil 7 ist über eine Datenleitung S3 mit der Kontrolleinrichtung 10 verbunden, sodass es von der Kontrolleinrichtung 190 ansteuerbar ist. Die Rückführung 8 kann - wie in Fig. 1 dargestellt - mit der Quelle 20 verbunden sein, sodass das Fluid bei entsprechender Ventilstellung vom Ventil 7 durch die Rückführung 8 zur Quelle 20 zurückströmen kann. Es ist aber auch möglich, dass die Rückführung 8 zu einem separaten Auffangbehälter führt.

Da Vorrichtungen und Verfahren zum Rotationsbeschichten (spin-coating) einer Oberfläche eines Substrats an sich hinlänglich bekannt sind, beispielsweise aus der Halbleitertechnologie, wird im Folgenden auf die prinzipielle Funktionsweise nicht näher eingegangen.

Beim Rotationsbeschichten wird der Wafer 11 auf dem Drehteller 2 (dem Chuck) beispielsweise mittels Vakuum- oder Saugtechnologie fixiert. De Drehteller 2 wird mittels der Antriebseinrichtung 3 in Rotation versetzt. Mit der Pumpe 5 wird eine vorgebbare Menge des Photoresists von der Quelle 20 zu der Abgabedüse 4 gefördert und von der Abgabedüse 4 auf den Wafer aufgebracht. Durch die Rotation des Ddrehtellers 2 mit dem Wafer 11 wird der Photoresist gleichmässig über die Oberfläche des Wafers 11 verteilt. Eventuell überschüssiges Material wird vom Wafer 11 abgeschleudert. Die Dicke und die Homogenität der erzeugten Schicht 12 hängt von mehreren Faktoren ab, wie beispielsweise Drehzahl des Drehtellers 2, Dauer der Rotation, Temperatur des Substrats 11, Umgebungstemperatur des Substrats 11 und Viskosität des Fluids, hier des Photoresists. Die Viskosität des Photoresists hängt wiederum von mehreren Parametern ab, insbesondere von der Temperatur des Photoresists und von seiner Zusammensetzung. So kann sich beispielsweise die Viskosität des Photoresists ändern, weil das Verhältnis aus Polymer und Lösungsmittel sich ändert. Derartige Effekte können sogar innerhalb eines Vorratsbehälters auftreten, beispielsweise weil sich die im allgemeinen grossen Polymermoleküle nicht homogen in dem Lösungsmittel verteilen. Dies kann über den Vorratsbehälter gesehen zu lokalen Dichteschwankungen und somit auch zu Viskositätsänderungen führen.

Um nach dem Aufbringen des Photoresists auf die Oberfläche des Wafers 11 eine feste Schicht zu erhalten, ist es notwendig, das Lösungsmittel zu entfernen. Ein Teil des Lösungsmittels verflüchtigt sich üblicherweise schon beim Aufschleudern. Dies kann durch einen beheizbaren Drehteller 2, durch anschliessendes Aufheizen des Wafers oder durch Rotation des Drehtellers, typischerweise mit im Vergleich zur Aufbringphase verringerter Drehzahl, unterstützt werden.

Im Allgemeinen ist es bekannt, z.B. anhand empirischer Daten, oder es kann durch Versuche ermittelt werden, wie die Parameter für die Rotation des Drehtellers 2, also insbesondere seine Drehzahl und seine Beschleunigung, eingestellt werden müssen, um für einen Photoresist gegebener Viskosität bei definierten Prozessparametern die gewünschte Dicke der Schicht 12 zu realisieren. Insbesondere für die Homogenität der Schichtdicke ist es wesentlich, die Beschichtung unter möglichst genauer Einhaltung der Parameter durchzuführen. Wenn es nun aber bei der Produktion zu Variationen in den Eigenschaften des Photoresist kommt, so kann dies zu einer fehlerhaften oder nicht befriedigenden Beschichtung der Oberfläche des Wafers 11 führen, weil entweder die Schichtdicke nicht mehr den vorgegebenen Wert aufweist oder weil die Variationen in der Schichtdicke zu stark sind. Solche Fehler oder Unzulänglichkeiten in der Schicht 12 können bei den bisher bekannten Verfahren erst nach der Herstellung der Schicht 12 detektiert werden. Zwar können dann gegebenenfalls Gegenmassnahmen getroffen werden, doch von den bereits beschichteten Wafern 11 muss die Photoresist Schicht wieder entfernt werden und es muss eine neue Photoresist Schicht aufgebracht werden.

Erfindungsgemäss ist daher das Viskosimeter 6 vorgesehen, mit welchem vor dem Aufbringen des Photoresists eine aktuelle Viskosität messtechnisch bestimmt wird. Bei dem in Fig. 1 dargestellten Ausführungsbeispiel fördert die Pumpe 5 den Photoresist durch die Zuführung 9 zum Viskosimeter 6, wo die aktuelle Viskosität des Photoresist in-line gemessen wird. Der messtechnisch bestimmte Wert der Viskosität wird über die Datenleitung S1 an die Kontrolleinrichtung 10 übermittelt. Die Kontrolleinrichtung 10 überprüft, ob der aktuelle Wert der Viskosität des Photoresist mit dem Soll-Wert übereinstimmt.

Überraschend ist dabei die Erkenntnis, dass sich mit dem Viskosimeter 6 insbesondere Änderungen in der Viskosität genau genug erfassen lassen. Es hat sich beispielsweise gezeigt, dass mit den vorzugsweise verwendeten Viskosimetern der Anmelderin Schwankungen in der Viskosität von nur einem Promille oder weniger zuverlässig nachweisbar bzw. erfassbar sind.

Der jeweilige Soll-Wert für die Viskosität des Photoresist kann in der Kontrolleinrichtung 10 in Abhängigkeit von anderen Parametern gespeichert sein, beispielsweise in Abhängigkeit von der Wafertemperatur, der Umgebungsfeuchte und/oder der Umgebungstemperatur bei der Beschichtung, der Art des Photoresist usw.

Somit kann vor jeder Beschichtung eines Wafers 11 überprüft werden, ob der aktuelle Wert der Viskosität des Photoresists für die jeweiligen Bedingungen mit dem Soll-Wert übereinstimmt. Durch diese Kontrolle lassen sich fehlerhafte bzw. qualitativ minderwertige Beschichtungen auf dem Wafer 11 zumindest deutlich reduzieren.

Bei dem ersten Ausführungsbeispiel gemäss Fig. 1 ist zur Beschichtung des Wafers 11 das Ventil 7 in einer Schaltstellung, in der die von der Pumpe 5 kommende Zuführung 9 mit der Abgabedüse 4 verbunden ist und die Strömungsverbindung zur Rückführung 8 verschlossen ist. Falls die Kontrolleinrichtung 10 detektieret, dass der aktuelle Wert der Viskosität des Photoresist von dem Soll-Wert abweicht, so schaltet sie über die Datenleitung S3 das Ventil 7 in eine Stellung, welche die von der Pumpe 5 kommende Zuführung 9 mit der Rückführung 8 verbindet, sodass das Fluid nicht zu der Abgabedüse 4 gelangen kann. Auf diese Weise wird eine mangelhafte Beschichtung des Wafers 7 vermieden. Es können dann Massnahmen getroffen werden, um die Viskosität wieder auf den richtigen Wert einzustellen.

Es ist auch möglich, dass die Kontrolleinrichtung 10 zur Kompensation der Abweichung der aktuellen Viskosität vom Soll-Wert über die Antriebseinrichtung 3 die Drehzahl des Drehtellers 2 verändert, sodass die Abweichung der Viskosität durch eine Änderung der Rotationsgeschwindigkeit des Drehtellers 2 kompensiert wird. Falls also die Kontrolleinrichtung anhand der vom Viskosimeter übermittelten Daten feststellt, dass die aktuelle Viskosität vom Soll-Wert abweicht, so ermittelt sie, z.B. mit Hilfe von look-up-Tabellen, empirischen Werten oder Berechnungen, welche Drehzahl des Drehtellers 2 zu dem aktuellen Wert der Viskosität gehört, um die gewünschte Schichtdicke und Homogenität zu realisieren. Über die Datenleitung S2 steuert die Kontrolleinrichtung 10 sodann die Antriebseinrichtung 3 an, welche den Drehteller 2 auf die ermittelte Drehzahl beschleunigt oder abbremst. In der Praxis hat sich beispielsweise gezeigt, dass eine Abweichung der Viskosität von 1 % recht gut durch eine Korrektur der Drehzahl um 0.5% korrigiert werden kann. Eine 3% zu hohe Viskosität wird beispielsweise durich eine Erhöhung der Drehzahl um 0.5 x 3% = 1.5% kompensiert. Eine 2% zu tiefe Viskosität wird durch eine Verringerung der Drehzahl um 0.5 x 2% = 1 % korrigiert.

Sollte es nicht möglich sein, die Änderung in der aktuellen Viskosität durch eine Drehzahländerung zu kompensieren, so besteht immer noch die Möglichkeit, über das Ventil 7 den Photoresist in die Rückführung 8 zu leiten.

Bei der folgenden Beschreibung der weiteren Ausführungsbeispiele sind gleiche oder gleichwertige Teile mit denselben Bezugszeichen wie in Fig. 1 bezeichnet. Die Erläuterungen bezüglich des ersten Ausführungsbeispiels gelten in sinngemäss gleicher Weise auch für die anderen Ausführungsbeispiele. Im Folgenden wird nur auf die Änderungen und Unterschiede im Vergleich zum ersten Ausführungsbeispiel eingegangen. Umgekehrt können einige Massnahmen und Ausgestaltungen der im Folgenden beschriebenen Ausführungsbeispiele auch für das erste Ausführungsbeispiel Verwendung finden.

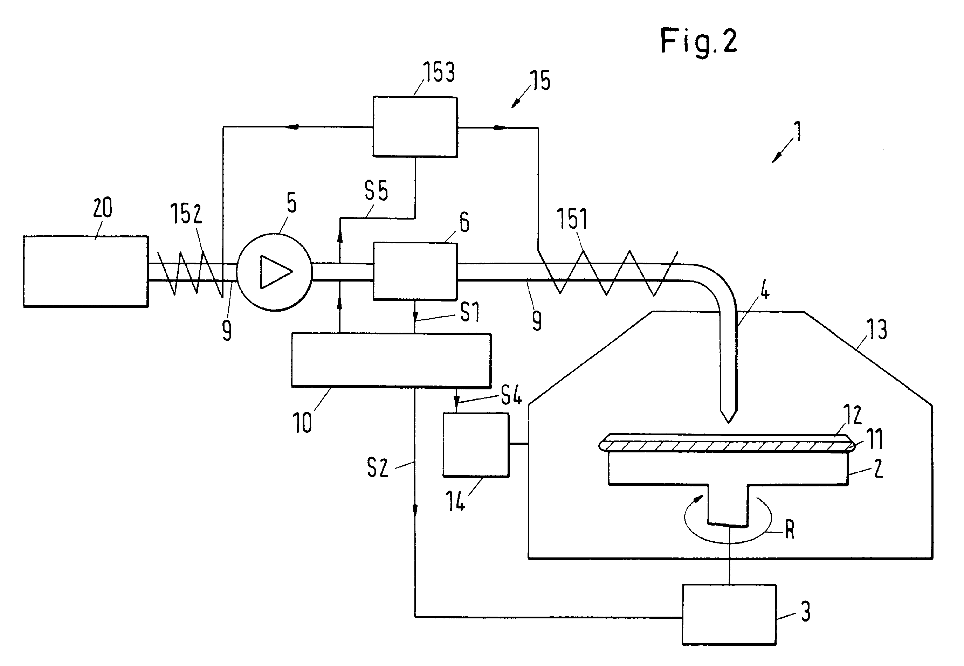

Fig. 2 zeigt ein zweites Ausführungsbeispiel einer erfindungsgemässen Vorrichtung zum Rotationsbeschichten. Bei diesem Ausführungsbeispiel ist zusätzlich eine Temperierung 15 zur Änderung der Temperatur des Fluids vorgesehen. Die Temperierung 15 umfasst eine Temperatursteuereinheit 153, mit welcher mindestens ein Temperierelement 151 ansteuerbar ist. Das Temperierelement 151 steht im Wärmekontakt mit dem Fluid und kann dem Fluid Wärme zuführen, um seine Temperatur zu erhöhen oder Wärme entziehen, um seine Temperatur zu erniedrigen. Das Temperierelement 151 ist im vorliegenden Fall stromabwärts des Viskosimeters 6 angeordnet, sodass es die Temperatur des Fluids nach Verlassen des Viskosimeters und vor Erreichen der Abgabedüse 4 verändern kann.

Optional kann alternativ oder ergänzend stromaufwärts des Viskosimeters 6 ein Temperierelement 152 vorgesehen sein, mit welchem die Temperatur des Fluids vor dessen Eintritt in die Pumpe verändert werden kann. Als eine weitere Variante ist es möglich, alternativ oder ergänzend die Temperatur des Fluids in der Quelle 20 zu verändern.

Die Temperatursteuereinheit 153 ist über eine Datenleitung S5 mit der Kontrolleinrichtung 10 verbunden.

Ferner ist bei dem zweiten Ausführungsbeispiel eine Prozesskammer 13 vorgesehen. Der Drehteller 2 mit dem Substrat 11 ist innerhalb der Prozesskammer 13 angeordnet. Ferner ist eine Klimaeinheit 14 vorgesehen, mit wellcher zumindest die Temperatur in der Prozesskammer 13 einstellbar ist. Vorzugsweise lassen sich mit der Klimaeinheit 14 auch noch weitere insbesondere atmosphärische Bedingungen in der Prozesskammer einstellen, beispielsweise die Feuchte. Die Klimaeinheit 14 ist über eine Datenleitung S4 mit der Kontrolleinrichtung 10 signalverbunden.

Optional kann auch bei diesem Ausführungsbeispiel eine Rückführung 8 und ein Ventil zum Öffnen dieser Rückführung vorgesehen sein.

Während des Betriebs wird mit dem Viskosimeter 6 jeweils der aktuelle Wert der Viskosität des Photoresits gemessen und über die Datenleitung S1 and die Kontrolleinrichtung übermittelt. Sobald eine Abweichung der aktuellen Viskosität von dem vorgegebenen Soll-Wert detektiert wird, kann die Kontrolleinrichtung 10 eine oder mehrere der folgenden Kompensationen einleiten, um der Variation in der Dicke der auf der Oberfläche des Wafers 11 aufgebrachten Schicht 12 entgegenzuwirken:

Wie bereits beim ersten Ausführungsbeispiel beschrieben kann die Kontrolleinrichtung über die Datenleitung S2 die Antriebseinrichtung 3 so ansteuern, dass diese die Drehzahl des Drehtellers erhöht oder erniedrigt, um die Änderung in der Viskosität auszugleichen.

Die Kontrolleinrichtung 10 kann über die Datenleitung S5 die Temperatursteuereinheit 153 so ansteuern, dass diese über das Temperierelement 151 die Temperatur des Photoresists derart ändert, dass die Viskosität wieder ihrem Soll-Wert annimmt. Anhand der in der Kontrolleinrichtung gespeicherten Daten kann in einfacher Weise ermittelt werden, um welchen Betrag die Temperatur des Photoresists erhöht oder erniedrigt werden muss, damit der aktuelle Wert wieder mit dem Soll-Wert in Übereinstimmung kommt. Für die folgenden Beschichtungsvorgänge kann dann optional mit dem Temperierelement 152 die Temperatur des Photoresists bereits in kontrollierter Weise verändert werden, bevor der Photoresist das Viskosimeter 6 erreicht. Im Viskosimeter 6 kann dann verifiziert werden, dass die Viskosität des Fluids tatsächlich den vorgegebenen Sollwert hat.

Die Kontrolleinrichtung kann über die Datenleitung S4 die Klimaeinheit 14 ansteuern, sodass diese die Temperatur in der Prozesskammer 13 und/oder andere Parameter wie beispielsweise die Feuchte derart ändert, dass die von der Abweichung der aktuellen Viskosität vom Soll-Wert bedingten Änderungen kompensiert werden.

Natürlich sind prinzipiell auch noch andere Kompensationen möglich, wie beispielsweise ein Heizen oder ein Kühlen des Wafers 11 auf dem Drehteller 2.

Es versteht sich, dass ferner Messfühler vorgesehen sein können, um Prozessparameter zu erfassen und an die Kontrolleinrichtung 10 weiterzuleiten, beispielsweise Sensoren für dir Temperatur des Fluids, für die Umgebungstemperatur in der Prozesskammer 13 oder für die Oberflächentemperatur des Wafers.

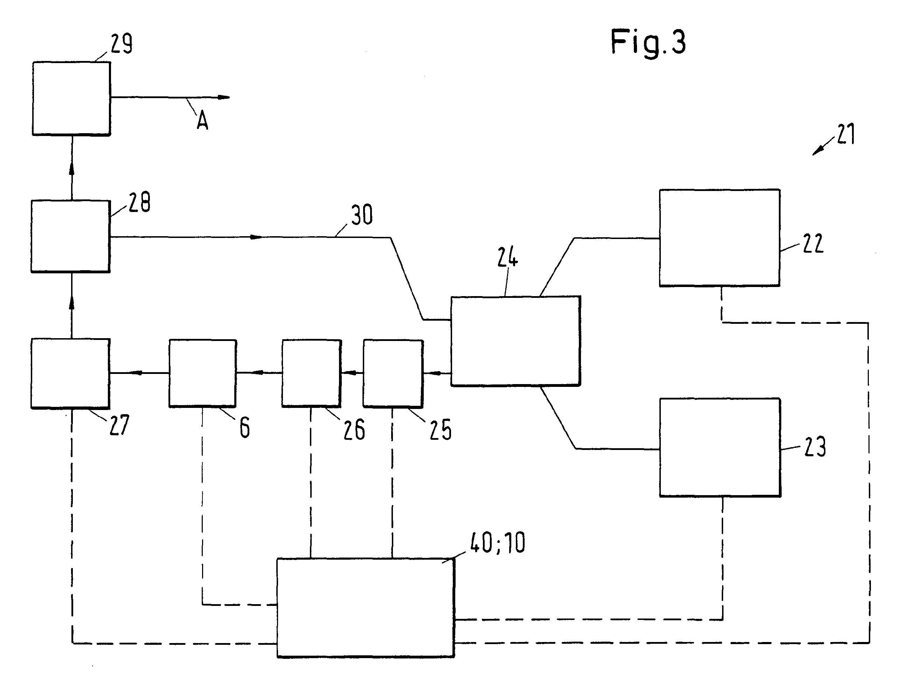

Vorzugsweise umfasst die erfindungsgemässe Vorrichtung zum Rotationsbeschichten eine Versorgungseinheit 21 als Quelle für das Fluid. Fig. 3 zeigt ein Ausführungsbeispiel einer Versorgungseinheit, die gesamthaft mit dem Bezugszeichen 21 bezeichnet. Die Versorgungseinheit 21 soll das Fluid, hier also den Photoresist, für die Beschichtung des Wafers 11 bereitstellen.

Insbesondere beim Rotationsbeschichten mit Polymerflüssigkeiten umfasst das Fluid für die Beschichtung mehrere Komponenten, nämlich mindestens ein Polymer und mindestens ein Lösungsmittel für das Polymer. Daher umfasst die Versorgungseinheit 21 einen ersten Vorratsbehälter 22 für eine erste Komponente des Fluids sowie einen zweiten Vorratsbehälter 23 für eine zweite Komponente des Fluids. Im vorliegenden Beispiel ist die erste Komponente die das Polymer enthaltende des Photoresists und die zweite Komponente das Lösungsmittel für das Polymer.

Jeder Vorratsbehälter 22,23 ist jeweils über eine Leitung mit einer Mischeinrichtung 24 verbunden, in welcher die beiden Komponenten innig miteinander vermischt werden. Die Mischeinrichtung 24 umfasst eine integrierte oder separate Pumpe, um das Fluid bzw. seine Komponenten zu fördern. Diese Pumpe kann ergänzend oder alternativ zur Pumpe 5 (siehe Fig. 1 und Fig. 2) vorgesehen sein. Die Mischeinrichtung 24 kann als dynamischer Mischer ausgestaltet sein oder als eine Pumpe mit nachgeschaltetem statischen Mischer.

Von der Mischeinrichtung 24 führt eine Leitung über ein Filter 25 zum Ausfiltern von Partikeln aus dem Fluid, über eine Temperiereinheit 26 zum Heizen oder Kühlen des Fluids zum Viskosimeter 6, wo der aktuelle Wert der Viskosität des Fluids bestimmt wird. Vom Ausgang des Viskosimeters 6 führt eine Leitung zu einem Durchflussmesser 27, um die durchströmende Fluidmenge messtechnisch zu erfassen und von dort zu einem Wegeventil 28, hier einem Dreiwegeventil, das die vom Durchflussmesser 27 kommende Leitung wahlweise mit einem Speichertank 29 verbindet oder mit einer Rezirkulationsleitung 30, durch welche das Fluid zurück zur Mischeinrichtung strömen kann.

Vom Speichertank führt dann eine mit dem Pfeil A angedeutete Leitung zur Abgabedüse 4 die in Fig. 3 nicht dargestellt ist. Natürlich können zwischen dem Speichertank 29 und der Abgabedüse 4 noch weitere Bauelemente wie beispielsweise eine weitere Pumpe oder eine weitere Temperierung vorgesehen sein. Ferner ist eine Steuer- und Regeleinheit 40 vorgesehen, die mit den Vorratsbehältern 22,23, der Mischeinrichtung 24, dem Filter 25, der Temperiereinheit 26, dem Viskosimeter 6, dem Durchflussmesser 27, und dem Wegeventil 28 signalverbunden ist, wie dies in Fig. 3 durch die gestrichelten Linien angedeutet ist.

Die Kontrolleinrichtung 10 (siehe Fig. 1, Fig. 2) ist mit der Steuer- und Regeleinheit 40 signalverbunden, vorzugsweise ist die Kontrolleinrichtung 10 in der Steuer- und Regeleinheit 40 integriert.

Es versteht sich, dass weitere Absperr-, Regel- oder Wegeventile vorgesehen sein können, um den Strom des Fluids bzw. seiner Komponenten zu kontrollieren.

Im Betrieb steuert nun die Steuer-und Regeleinheit 40 die beiden Vorratsbehälter 22,23 so an, dass diese jeweils eine für das vorgebbare Mischungsverhältnis der Komponenten geeignet Menge der jeweiligen Komponente an die Mischeinrichtung 24 abgeben, wo die beiden Komponenten innig vermischt werden, um das Fluid für die Beschichtung zu generieren. Diese Fluid wird durch das Filter 25 zur Temperiereinheit 26 gefördert, wo das Fluid auf die vorgebbare Temperatur gebracht wird. Anschliessend wird in dem Viskosimeter 6 der aktuelle Wert der Viskosität messtechnisch ermittelt und an die Steuer-und Regeleinheit 40 übermittelt. Nach Durchströmen des Durchflussmessers 27 erreicht das Fluid das Wegeventil 28. Falls die Steuer- und Regeleinheit ermittelt hat, dass der aktuelle Wert der Viskosität des Fluids dem Soll-Wert entspricht, so schaltet sie das Wegeventil 28 in die Stellung, in der das Fluid in den Speichertank 29 einströmen kann, um von dort zue Abgabedüse 4 gefördert zu werden.

Hat die Steuer- und Regeleinheit festgestellt, dass der aktuelle Wert der Viskosität von dem Soll-Wert abweicht, so steuert sie das Wegeventil 28 so an, dass es die Strömungsverbindung zum Speichertank 29 verschliesst und dafür die Strömungsverbindung in die Rezirkulationsleitung 30 öffnet sodass das Fluid in die Mischeinrichtung 24 zurückströmt.

Zur Kompensation der Abweichung der aktuellen Viskosität vom Soll-Wert der Viskosität kann die Steuer- und Regeleinheit 40 die Temperiereinheit 26 so ansteuern, dass diese das Fluid auf eine höhere Temperatur aufheizt oder auf eine niedrigere Temperatur abkühlt, um so die aktuelle Viskosität des Fluids derart zu ändern, dass sie mit dem Soll-Wert übereinstimmt.

Alternativ oder ergänzend besteht die Möglichkeit das die Steuer- und Regeleinheit den ersten und den zweiten Vorratsbehälter so ansteuert, dass das Mengenverhältnis der Komponenten des Fluids auf einen anderen Wert eingestellt wird. Ist beispielsweise der aktuelle Wert der Viskosität des Fluids zu hoch, so steuert die Steuer- und Regeleinheit den ersten bzw. den zweiten Vorratsbehälter 22, 23 so an, dass der Anteil an Lösungsmittel im Photoresist erhöht wird, wodurch sich seine aktuelle Viskosität verkleinert.

Das Fluid, hier als der Photoresist, wird solange in der Versorgungseinheit 21 rezirkuliert, bis der aktuelle Wert der Viskosität mit dem vorgegebenen Soll-Wert übereinstimmt, und wird erst dann in den Speichertank geleitet, um für das Rotationsbeschichten bereitzustehen.

Es versteht sich, dass auch bei der Ausführungsform gemäss Fig. 3 die Drehzahl bzw. die Rotationsgeschwindigkeit des Drehtellers 2 geändert werden kann, um Abweichungen in der aktuellen Viskosität des Fluids vom Soll-Wert zu kompensieren.

## Patentansprüche

1. Vorrichtung zum Rotationsbeschichten einer Oberfläche eines Substrats mit einem Fluid, insbesondere der Oberfläche eines Wafers mit einer Polymerflüssigkeit, speziell mit einem Photoresist, welche einen Drehteller (2) zum Aufnehmen des Substrats (11) umfasst, eine Antriebseinrichtung (3) zum Rotieren des Drehtellers (2), eine Abgabedüse (4) zum Aufbringen einer vorgebbaren Menge von Fluid auf die Oberfläche des Substrats (11) zwecks Bildung einer Schicht (12), sowie eine Pumpe (5) zum Fördern des Fluids, die einerseits mit einer Quelle (20) für das Fluid und andererseits mit der Abgabedüse (4) verbindbar ist, **dadurch gekennzeichnet, dass** ein Viskosimeter (6) vorgesehen ist, mit welchem vor dem Aufbringen des Fluids dessen aktuelle Viskosität messtechnisch bestimmbar ist.

2. Vorrichtung nach Anspruch 1 mit einer Kontrolleinrichtung (10), welche mit dem Viskosimeter signalverbunden ist und beim Abweichen der aktuellen Viskosität des Fluids von einem Soll-Wert eine Kompensation einleitet, mit der Variationen in der Dicke der auf der Oberfläche aufzubringenden Schicht (12) entgegengewirkt wird.

3. Vorrichtung nach einem der vorangehenden Ansprüche, bei welcher eine Temperierung (15) zur Änderung der Temperatur des Fluids vorgesehen ist.

4. Vorrichtung nach einem der vorangehenden Ansprüche, wobei der Drehteller (2) zum Aufnehmen des Substrats (11) in einer Prozesskammer (13) vorgesehen ist, und mit einer Klimaeinheit (14), mit welcher zumindest die Temperatur in der Prozesskammer (13) einstellbar ist.

5. Vorrichtung nach einem der vorangehenden Ansprüche, bei welcher als Quelle für das Fluid eine Versorgungseinheit (21) vorgesehen ist, mit einem ersten Vorratsbehälter (22) für eine erste Komponente des Fluids, mit einem zweiten Vorratsbehälter (23) für eine zweite Komponente des Fluids, mit einer Mischeinrichtung (24) zum Durchmischen der Komponenten des Fluids, sowie mit einer Steuer-und Regeleinheit (40), mit welcher das Mengenverhältnis der Komponenten des Fluids einstellbar ist.

6. Vorrichtung nach Anspruch 5, bei welcher das Viskosimeter (6) in der Versorgungseinheit (21) vorgesehen ist.

7. Vorrichtung nach einem der Ansprüche 2 bis 6, bei welchem die Kompensation zumindest eine der folgenden Massnahmen umfasst:
Änderung der Temperatur des Fluids, Änderung der Rotationsgeschwindigkeit des Drehtellers (2), Änderung der Temperatur in der Prozesskammer (13); Änderung der Zusammensetzung des Fluids durch Änderung des Mengenverhältnisses der Komponenten des Fluids.

8. Verfahren zum Rotationsbeschichten einer Oberfläche eines Substrats mit einem Fluid, insbesondere der Oberfläche eines Wafers mit einer Polymerflüssigkeit, speziell mit einem Photoresist, bei welchem Verfahren das Substrat (11) auf einem Drehteller (2) angeordnet wird, der Drehteller (2) rotiert wird, mit einer Abgabedüse (4) eine vorgebbare Menge des Fluids auf die Oberfläche des Substrats (11) zwecks Bildung einer Schicht (12) aufgebracht wird, wobei das Fluid mittels einer Pumpe (5) von einer Quelle (20) für das Fluid zu der Abgabedüse (4) gefördert wird, **dadurch gekennzeichnet, dass** vor dem Aufbringen des Fluids dessen aktuelle Viskosität mittels eines Viskosimeters (6) messtechnisch bestimmt wird.

9. Verfahren nach Anspruch 8, bei welchem mittels einer Kontrolleinrichtung (10), die mit dem Viskosimeter (6) signalverbunden ist, die aktuelle Viskosität des Fluids mit einem Soll-Wert verglichen wird und im Falle einer Abweichung eine Kompensation eingeleitet wird, mit der Variationen in der Dicke der auf der Oberfläche aufzubringenden Schicht (12) entgegengewirkt wird.

10. Verfahren nach einem der Ansprüche 8-9, bei welchem die aktuelle Viskosität in einer als Quelle für das Fluid vorgesehenen Versorgungseinheit (21) mittels eines Viskosimeters (6) messtechnisch bestimmt wird.

11. Verfahren nach Anspruch 9 bei welchem als Kompensation zumindest eine der folgenden Massnahmen durchgeführt wird:
Änderung der Temperatur des Fluids, Änderung der Rotationsgeschwindigkeit des Drehtellers (2), Änderung der Temperatur in einer Prozesskammer (13) für den Drehteller (2), Änderung der Zusammensetzung des Fluids durch Änderung des Mengenverhältnisses von Komponenten des Fluids.
